# EUROPÄISCHE PATENTSCHRIFT

(11) **EP 4 435 273 B1**
(45) Veröffentlichungstag und Bekanntmachung des Hinweises auf die Patenterteilung: **02.12.2026**
(21) Anmeldenummer: 24156231.3
(22) Anmeldetag: 07.02.2024
(51) Int. Cl.: F15B 13/044, F15B 21/04, F16K 49/00, F16K 31/06, H01F 7/06, F16H 61/00

(54) **ELEKTROHYDRAULISCHE STEUERVORRICHTUNG UND VERFAHREN ZUR HERSTELLUNG EINER ELEKTROHYDRAULISCHEN STEUERVORRICHTUNG**
ELECTROHYDRAULIC CONTROL DEVICE AND METHOD FOR PRODUCING AN ELECTROHYDRAULIC CONTROL DEVICE
DISPOSITIF DE COMMANDE ÉLECTROHYDRAULIQUE ET PROCÉDÉ DE FABRICATION D'UN DISPOSITIF DE COMMANDE ÉLECTROHYDRAULIQUE

(30) Priorität: 21.03.2023 DE 102023202474
(43) Veröffentlichungstag der Anmeldung: 25.09.2024
(73) Patentinhaber: Robert Bosch GmbH, 70442 Stuttgart (DE)
(72) Erfinder: Komar, Nandor, 1045 Budapest (HU); Varga, Eszter, 1052 Budapest (HU); Pozsega, Peter, 2011 Budakalasz (HU); Hittaller, Adam, 1103 Budapest (HU)

(56) Entgegenhaltungen:
- DE-B4- 10 130 833
- DE-B4- 102005 034 367
- US-A- 5 957 547

## Beschreibung

### Stand der Technik

Im Stand der Technik werden elektrohydraulische Aktuatoren zur Steuerung in Hydrauliksystemen eingesetzt und weisen einen Elektromagneten mit einer Magnetspule und ein Ventilteil mit einem Ventilelement auf. Das mittels des Elektromagneten betätigte Ventilelement kann verschiedenartig ausgebildete Einlass- und Auslassöffnungen an dem Ventilteil öffnen oder verschließen und dadurch eine Druckeinstellung an einem oder mehreren hydraulischen Verbrauchern oder einem Druckkanal vornehmen. Die Ansteuerung derartiger elektrohydraulischer Aktuatoren kann über ein Steuergerät erfolgen, welches den elektrischen Strom durch die Spule des Elektromagneten einstellt.

Im Stand der Technik sind elektrohydraulische Steuervorrichtungen bekannt, die beispielsweise in der Kraftfahrzeugtechnik im Getriebe eingesetzt werden und in der Regel als komplexe Elektronikmodule mit Drucksensoren, Drehzahlsensoren und weiteren Funktionen ausgestaltet sind und der Ansteuerung mehrerer elektrohydraulischer Aktuatoren dienen. So ist beispielsweise aus der DE 101 30 833 B4 eine elektrohydraulische Steuervorrichtung bekannt, die einen mit Hydraulikkanälen versehenen Hydraulikblock mit einer Bestückungsseite aufweist. An dem Hydraulikblock sind mehrere elektrohydraulische Aktuatoren angeordnet, die von der Bestückungsseite aus mit einem Ventilabschnitt in jeweils eine Aufnahmeöffnung des Hydraulikblocks eingreifen. Ein elektronisches Steuergerät umfasst eine als großflächige Verbindungsisolationslage mit darin eingebetteten Leiterbahnen ausgebildete Leiterplatte. Ein zentraler Abschnitt dieser Leiterplatte fungiert als Schaltungsträger und ist mit den elektronischen Bauelementen einer Steuerschaltung bestückt, die mit einem auf die Leiterplatte aufgesetzten Deckelteil abgedeckt sind. Die Leiterplatte ist seitlich über das Deckelteil nach außen geführt und weist an ihren Rändern elektrische Kontaktmittel auf, die jeweils mit den elektrischen Anschlüssen eines elektrohydraulischen Aktuators elektrisch kontaktiert sind.

Bei den bekannten Lösungen erfolgt die Ansteuerung aller Aktuatoren gewöhnlich über eine gemeinsame elektronische Steuereinheit (ECU = Electronic Control Unit), welche beispielsweise über einen Mikroprozessor die erforderlichen Stellströme für die Aktuatoren ermitteln kann und die Stellströme über in die Steuereinheit integrierte Endstufenbausteine für die Elektromagneten der Aktuatoren bereitstellen. Die ECU verfügt über mehrere Endstufen, so dass mehrere Aktuatoren über diese ECU angesteuert werden können.

Neuere Entwicklungen und Einsatzfelder elektrohydraulischer Steuervorrichtungen erfordern, dass die elektrohydraulischen Aktuatoren nicht mehr über einen Endstufenbaustein in einem zentralen Steuergerät betrieben werden, sondern nur noch über ein BUS-System angesprochen werden (z.B. CAN oder LIN). Der für die Erzeugung der Stellkräfte notwendige Stellstrom muss dann jedoch im oder am Aktuator aus einer Batteriespannung erzeugt werden. Es besteht somit ein Bedarf an hydraulischen Aktuatoren, die mit einem daran angeordneten und direkt dem Aktuator zugeordneten elektronischen Steuergerät an einem Hydraulikblock zu einer kleinen, flexible einsetzbaren Baueinheit verbaut werden können.

Hier besteht die Problematik, dass zur Erzeugung einer hohen Magnetkraft im Elektromagneten des Aktuators ein hoher Stellstrom benötigt wird. Fließt dieser hohe Stellstrom durch die für die Felderzeugung benötigte Magnetspule, ergibt sich aufgrund des Eigenwiderstands der Spule eine Verlustleistung, die zu einer Eigenerwärmung des Elektromagneten führt. Die im Steuergerät verbaute Elektronik erzeugt darüber hinaus selbst Wärme, die zu einer weiteren Temperaturerhöhung führt. Dies sorgt für eine Erwärmung sowohl des Steuergeräts als auch der Magnetspule des Aktuators. Nachteilig dabei ist, dass das Steuergerät und der Elektromagnet sich gegenseitig aufwärmen und eine zulässige maximale Temperatur überschreiten können. Würde der Elektromagnet jedoch mit einem geringeren Stellstrom betrieben, so hätte dies eine geringere Stellkraft des Aktuators und damit Leistungseinbußen zur Folge.

Aus der US 5 957 547 A ist eine elektrohydraulische Steuervorrichtung mit den Merkmalen des Oberbegriffs des Anspruchs 1 bekannt.

Aus der DE 10 2005 034 367 B4 ist eine elektronische Steuerungsvorrichtung für ein Automatikgetriebe bekannt mit einem in einem Gehäuse des Automatikgetriebes angeordneten Substrat, auf dem eine elektronische Schaltung zum Steuern des Automatikgetriebes angeordnet ist, wobei in dem Gehäuse eine Kapsel angeordnet ist, die aus einem Material mit einer geringen Wärmeleitfähigkeit hergestellt ist und das Substrat flüssigkeitsdicht aufnimmt und wobei ein Wärmeableitelement am Substrat befestigt ist, das Wärme von der elektronischen Schaltung ableitet und in Kontakt an einer Innenwandfläche der Kapsel befestigt.

### Offenbarung der Erfindung

Die Erfindung betrifft eine elektrohydraulische Steuervorrichtung, umfassend einen mit wenigstens einem Hydraulikkanal versehenen Hydraulikblock mit einer Bestückungsseite, einem mit einem Ventilabschnitt in eine Aufnahmeöffnung des Hydraulikblocks eingreifenden elektrohydraulischen Aktuator und einem auf der Bestückungsseite des Hydraulikblocks befestigten elektronischen Steuergerät, wobei das Steuergerät einen als Leiterplatte ausgebildeten Schaltungsträger mit darauf angeordneten elektronischen Bauelementen und elektrische Kontaktmittel aufweist, die mit elektrischen Anschlüssen des elektrohydraulischen Aktuators elektrisch kontaktiert sind, wobei die Leiterplatte vollständig in einem geschlossenen und nach außen abgedichteten Steuergerätegehäuse des Steuergerätes auf einer in das Steuergerätegehäuse integrierten Kühlstruktur angeordnet ist und die Kühlstruktur wärmeleitend mit der Bestückungsseite des Hydraulikblocks kontaktiert ist, wobei das Steuergerätegehäuse ein Gehäuseunterteil und ein auf das Gehäuseunterteil aufgesetztes Gehäusedeckelteil aufweist und wobei und das Gehäuseunterteil aus einem elektrisch nichtleitenden Kunststoff mit in das Gehäuseunterteil eingebetteten Stanzgitterteilen gefertigt ist. Erfindungsgemäß ist vorgesehen, dass der Aktuator von der Bestückungsseite aus mit dem Ventilabschnitt in die Aufnahmeöffnung eingreift und das elektronische Steuergerät auf der Bestückungsseite neben dem elektrohydraulischen Aktuator befestigt ist, wobei von der Leiterplatte abgewandte Endabschnitte von ersten Stanzgitterteilen die elektrischen Kontaktmittel ausbilden und wobei von der Leiterplatte abgewandte Endabschnitte zweiter Stanzgitterteile zur elektrischen Kontaktierung von in das Gehäusedeckelteil eingebetteten dritten Stanzgitterteilen ausgebildet sind.

### Vorteile der Erfindung

Dadurch, dass die Leiterplatte vollständig in einem geschlossenen und nach außen abgedichteten Steuergerätegehäuse des Steuergerätes auf einer in das Steuergerätegehäuse integrierten Kühlstruktur angeordnet ist und die Kühlstruktur wärmeleitend mit der Bestückungsseite des Hydraulikblocks kontaktiert ist, wird vorteilhaft ein effizienter Wärmeableitungspfad für die durch die elektronischen Bauelemente erzeugte Wärme ermöglicht, welche sehr schnell auf den Hydraulikblock übertragen werden kann. Der Hydraulikblock weist Hydraulikkanäle auf, in denen ein Hydraulikfluid fließt, dessen Betriebstemperatur gewöhnlich unterhalb von 95° C liegt. Die Betriebstemperatur der elektronischen Schaltung auf dem Schaltungsträger des Steuergerätes kann jedoch Temperaturwerte von beispielsweise 160° C erreichen. Durch die thermische Anbindung der Leiterplatte über die Kühlstruktur an den Hydraulikblock erfolgt daher aufgrund des Temperaturgradients eine sehr gute Wärmeableitung auf den Hydraulikblock. Dennoch ist die mit den Bauelementen versehene Leiterplatte zum Schutz der elektronischen Bauelemente vollständig in einem geschlossenen und nach außen abgedichteten Steuergerätegehäuse verbaut. Das zur Ansteuerung eines Aktuators bestimmte Steuergerät kann somit bauraumsparend ausgebildet sein und vorteilhaft auf einfache Weise in unmittelbarer Nähe des zugeordneten elektrohydraulischen Aktuators als diskrete Einheit angeordnet werden. Die Herstellung des Gehäuseunterteils als Spritzgussteil aus einem beispielsweise thermoplastischen, nichtleitendem Kunststoffmaterial ermöglicht nicht nur die Integration eines Kühlblocks, sondern außerdem, in das Gehäuseunterteil Stanzgitterteile einzubetten, die mit der Leiterplatte im Gehäuseinnenraum elektrisch kontaktiert werden können. Die von der Leiterplatte abgewandten Endabschnitte erster Stanzgitterteile bilden dabei vorteilhaft die elektrischen Kontaktmittel für die Weiterkontaktierung zum elektrohydraulischen Aktuator aus. Von der Leiterplatte abgewandte Endabschnitte zweiter Stanzgitterteile sind zur elektrischen Kontaktierung von in das Gehäusedeckelteil eingebetteten dritten Stanzgitterteilen ausgebildet.

Die dritten Stanzgitterteile können mit ihren freien Endabschnitt an dem Gehäusedeckelteil vorteilhaft einen Gehäusestecker für die Kontaktierung an einen Kabelbaum ausbilden oder mit einem solchen Gehäusestecker kontaktiert sein.

Vorteilhaft ermöglicht die elektrohydraulische Steuervorrichtung daher eine flexible Einsatzmöglichkeit in Kombination mit einer raschen Wärmeableitung der von den Bauelementen erzeugten Wärme auf den Hydraulikblock. Durch eine in dem Steuergerätegehäuse integrierte Kühlstruktur, welche wärmleitend mit der Leiterplatte verbunden ist, erfolgt vorteilhaft eine rasche Wärmeableitung auf den Hydraulikblock. Die Kühlstruktur kann dabei in unterschiedlicher Weise ausgebildet sein und dient dazu die Wärme aus dem geschlossenen Steuergerätegehäuse nach außen abzuleiten.

Vorteilhafte Ausgestaltungen und Weiterbildungen der Erfindung ermöglichen die in den abhängigen Ansprüchen enthaltenen Merkmale.

In der bevorzugten Ausführungsform ist das elektronische Steuergerät der elektrohydraulischen Steuervorrichtung zur Ansteuerung nur eines elektrohydraulischen Aktuators vorgesehen und diesem daher auch direkt zugeordnet.

Für die Kühlstruktur bestehen unterschiedliche Ausführungsmöglichkeiten.

Beispielsweise kann die Kühlstruktur bereits durch einen Gehäusewandabschnitt eines beispielsweise metallischen Bodenteils des Steuergerätegehäuses ausgebildet sein, auf welchen die Leiterplatte mit einem Wärmeleitkleber aufgebracht ist. Erfindungsgemäß weist das Steuergerätegehäuse ein Gehäuseunterteil und ein auf das Gehäuseunterteil aufgesetztes Gehäusedeckelteil auf. In einem besonders vorteilhaften Ausführungsbeispiel umfasst die Kühlstruktur einen in das

Gehäuseunterteil eingelassenen Kühlblock, der über ein thermisches Ankoppelmaterial unmittelbar mit der Leiterplatte wärmeleitend verbunden ist. Der Kühlblock kann aus Metall gebildet werden. Insbesondere ist es möglich, den Kühlblock teilweise mit einem Kunststoffmaterial des Gehäuseunterteils im Spritzgussverfahren zu umspritzen. Auf diese Weise kann sehr leicht erreicht werden, dass der Kühlblock beispielsweise in den Boden des Gehäuseunterteils eingelassen ist. Die das Gehäuseunterteil bildende Spritzgussmasse umschließt dabei den Kühlblock wenigstens an den Seitenwänden. Um die Dichtwirkung zu erhöhen, kann der Kühlblock seitliche Rippen oder einen Kragen aufweisen, der umlaufend in den Kunststoff des Gehäuseunterteils eingreift.

Die Anordnung der elektrohydraulischen Steuervorrichtung erfolgt oft an Orten, welche mit aggressiven Medien kontaminiert sind. Insbesondere Hydrauliköle können im ungünstigen Fall in Spalte zwischen dem Kühlblock und der Spritzgussmasse des Gehäusebodens eindringen und entlang solcher Spalte in den Gehäuseinnenraum eindringen. Daher ist es vorteilhaft, den Kühlblock nicht gänzlich durch das Gehäuseunterteil hindurchzuführen, sondern durch einen in der Wanddicke verjüngten Gehäusewandabschnitt des Bodens vom Außenraum des Steuergerätegehäuses zu trennen. In diesem Falls ist die gesamte Gehäuseunterseite spaltfrei ausgebildet und der Kühlblock wird beispielsweise nur so weit in das Gehäuseunterteil eingelassen, dass er dieses nicht vollständig durchdringt.

Vorteilhaft kann der Boden des Gehäuseunterteils an einer der Kühlstruktur gegenüberliegenden Seite mittels eines weiteren thermisches Ankoppelmaterials direkt auf die Bestückungsseite des Hydraulikblocks wärmeleitend aufgebracht sein. Der Wärmableitungspfad führt dann die Wärme der Leiterplatte über ein erstes Ankoppelmaterial direkt an den Kühlblock ab. Dieser leitet die Wärme direkt oder über den dünnwandigen Gehäusewandabschnitt des Bodens ab. Von der Unterseite des Gehäusebodenteils aus wird die Wärmeenergie sodann über das weitere thermische Ankoppelmaterial auf den Hydraulikblock übertragen.

Obwohl es möglich ist, die der Leiterplatte zugewandten Endabschnitte der ersten Stanzgitterteile und/oder der zweiten Stanzgitterteile mit der Leiterplatte zu verlöten, ist es vorteilhaft diese als Presskontakte in die Leiterplatte einzupressen, wodurch die Montage der Leiterplatte im Steuergerätegehäuse vereinfacht wird. Natürlich ist es auch möglich die eingepressten Endabschnitte zusätzlich mit Kontaktflächen der Leiterplatte zu verlöten.

Der elektrohydraulische Aktuator kann eine Magnetspule und einen zur Auflage auf die Bestückungsseite des Hydraulikblocks ausgebildeten Flansch aufweisen, der beispielsweise aus einer elektrische isolierenden Spritzgussmasse um die Magnetspule herum angebracht ist. Kontaktelemente des Aktuators, die beispielsweise als Stanzgitterteile ausgebildet sind, können in den Flansch eingebettet sein. Die Kontaktelement stehen mit ihren ersten Enden aus dem Flansch hervor und sind mit ihren zweiten Enden mit den Spulenkontakten der Magnetspule beispielsweise verschweißt. Die Schweißstellen sind durch die Spritzgussmasse des Flanschs abgedeckt und daher geschützt. Die von der Magnetspule abgewandte Enden der Kontaktelemente bilden vorteilhaft die elektrischen Anschlüsse, welche mit den elektrischen Kontaktmitteln des Steuergerätes direkt kontaktiert werden können.

Der elektrohydraulische Aktuator kann zunächst an der Hydraulikplatte montieren werden. Erst anschließend kann das elektronische Steuergerät auf der Bestückungsseite in einfacher Weise montiert werden. Das Steuergerät wird mit dem Boden des Gehäuseunterteils auf die Bestückungsseite einfach aufgesetzt. Hierzu kann ein gegebenenfalls vorgesehenes weiteres thermisches Ankoppelmaterial zunächst auf den Hydraulikblock aufgetragen werden und das Steuergerät sodann darauf aufgesetzt werden. Beim Aufsetzen des Steuergerätes können die elektrischen Kontaktmittel des Steuergerätes direkt mit den elektrischen Anschlüssen des elektrohydraulischen Aktuators beispielsweise durch eine Presskontaktierung kontaktiert werden. Zur Abdichtung der Kontaktstelle kann beispielsweise eine Dichtung zwischen dem Flansch und dem Gehäusedeckelteil eingesetzt werden. Das elektronische Steuergerät kann dann durch Befestigungsmittel in einfacher Weise an dem Hydraulikblock befestigt werden.

### Kurze Beschreibung der Zeichnungen

Nachfolgend werden mögliche Ausführungsformen der Erfindung unter Bezugnahme auf die beiliegenden Figuren erläutert. In der Zeichnung zeigen:
- Figur 1: einen Querschnitt durch ein Ausführungsbeispiel einer erfindungsgemäßen elektrohydraulischen Steuervorrichtung,
- Figur 2: einen Querschnitt durch ein Gehäusebodenteil des Steuergerätegehäuses der Steuervorrichtung auf Figur 1 mit darin eingesetzter Leiterplatte,
- Figur 3: das elektronische Steuergerät aus Figur 2 mit aufgesetztem Gehäusedeckelteil,
- Figur 4: eine Möglichkeit der Ausbildung von Befestigungsmitteln für das Gehäusedeckelteil an dem Gehäusebodenteil,
- Figur 5: den Hydraulikblock auf Figur 1 mit dem daran angeordneten elektrohydraulischen Aktuator vor der Aufbringung des elektronischen Steuergerätes.

### Ausführungsformen der Erfindung

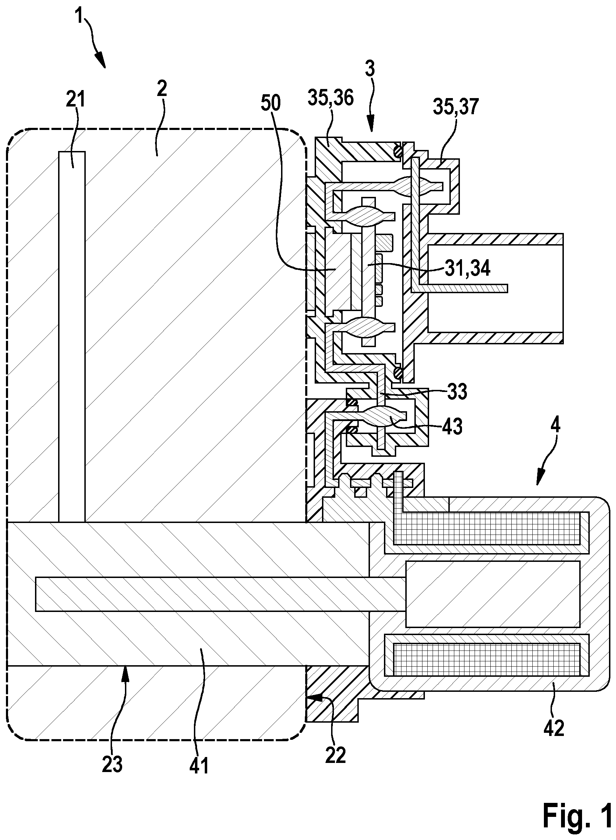

Figur 1 zeigt einen Querschnitt durch ein Ausführungsbeispiel einer erfindungsgemäßen elektrohydraulischen Steuervorrichtung 1. Eine derartige Vorrichtung kann in verschiedenen Hydrauliksystemen verbaut werden. Vorstellbar ist beispielsweise der Einsatz in einem Kraftfahrzeuggetriebe zur Einstellung des Arbeitsdruck in einer Hydraulikleitung für Getriebeschaltelemente oder Getriebekupplungen oder die Verwendung in einem hydraulischen Hilfsaggregat einer stationären oder mobilen Einrichtung sowie die Verwendung in einem Kühlsystem beispielsweise einer Klimaanlage, mit einer in den Hydraulikkanälen strömenden Kühlflüssigkeit. Die elektrohydraulische Steuervorrichtung 1 umfasst einen Hydraulikblock 2, ein elektronisches Steuergerät 3 und einen elektrohydraulischen Aktuator 4, die als separate Teile hergestellt werden können.

Der Hydraulikblock 2 besteht aus Metall und weist beispielsweise einen als Bohrung ausgebildeten Hydraulikkanal 21 auf, der mit einem hydraulischen Fluid gefüllt werden kann, bei dem es sich vorzugsweise um eine Flüssigkeit handelt. Natürlich kann der Hydraulikblock noch weitere, hier nicht dargestellte Kanäle aufweisen. Der Hydraulikblock 2 kann als Platte oder in anderer Weise ausgebildet sein und weist eine Bestückungsseite 22 auf, welche zur Anordnung des elektronischen Steuergerätes 3 und des elektrohydraulischen Aktuators 4 vorgesehen ist. Die Bestückungsseite 2 ist im dargestellten Ausführungsbeispiel vorzugsweise als ebene Fläche ausgebildet, kann aber auch andere Topografien aufweisen. Von der Bestückungsseite 22 aus erstreckt sich eine mit dem Hydraulikkanal 21 verbundene Aufnahmeöffnung 23 in den Hydraulikblock 2, die ebenfalls als Bohrungen ausgebildet sein kann.

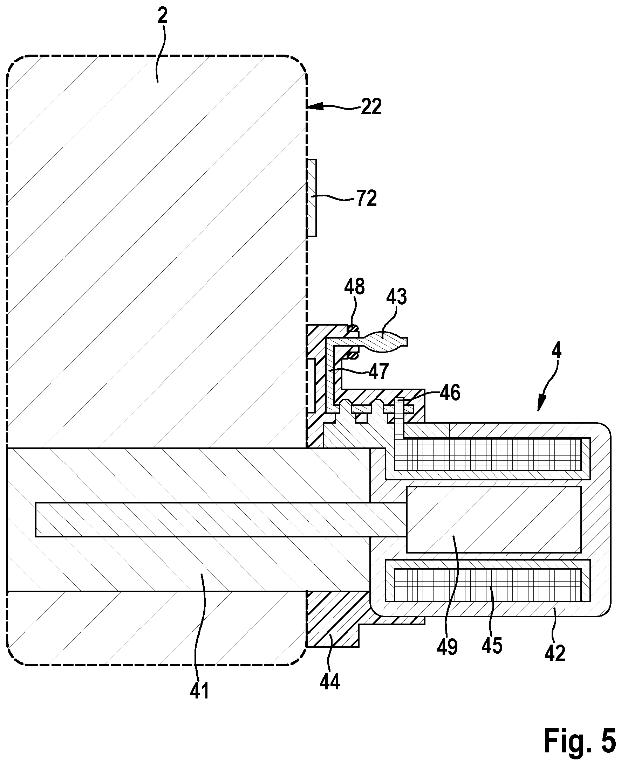

Der elektrohydraulische Aktuator 4 kann beispielsweise als elektromagnetisches Druckregelventil ausgebildet sein und weist einen Ventilabschnitt 41 und einen sich daran anschließenden Elektromagneten 42 auf. Der Elektromagnet 42 kann eine in Figur 5 gezeigte Magnetspule 45 umfassen, in der ein beweglicher Anker 49 gelagert sein kann. Der Anker 49 kann direkt oder indirekt ein nicht dargestelltes, in dem Ventilabschnitt 41 bewegliches Ventilelement betätigen, welches nicht dargestellte Anschlussöffnungen des Ventilabschnitts 21 verschließt oder öffnet und so den Zufluss oder Abfluss von Hydraulikfluid in dem Hydraulikkanal 21 steuert. In Hinblick auf die Einzelheiten eines Beispielhaften Aufbaus eines Druckregelventils sei auf die DE 10 2013 226 615 A1 verwiesen. Grundsätzlich andere Aufbauten sind natürlich auch möglich.

Das elektronisches Steuergerät 3 weist ein Steuergerätegehäuse 35 auf. Das Steuergerätegehäuse umfasst ein Gehäuseunterteil 35 und ein auf das Gehäuseunterteil 35 aufgesetztes Gehäusedeckelteil 36. Im Gehäuseinnenraum des Steuergerätegehäuses 35 ist ein als Leiterplatte 34 ausgebildeter Schaltungsträger 31 angeordnet. Die Leiterplatte 34 ist vollständig in dem geschlossenen und nach außen abgedichteten Steuergerätegehäuse 35 auf einer in das Steuergerätegehäuse 35 integrierten Kühlstruktur 50 angeordnet, welche wärmeleitend mit der Bestückungsseite 22 des Hydraulikblocks 2 kontaktiert ist.

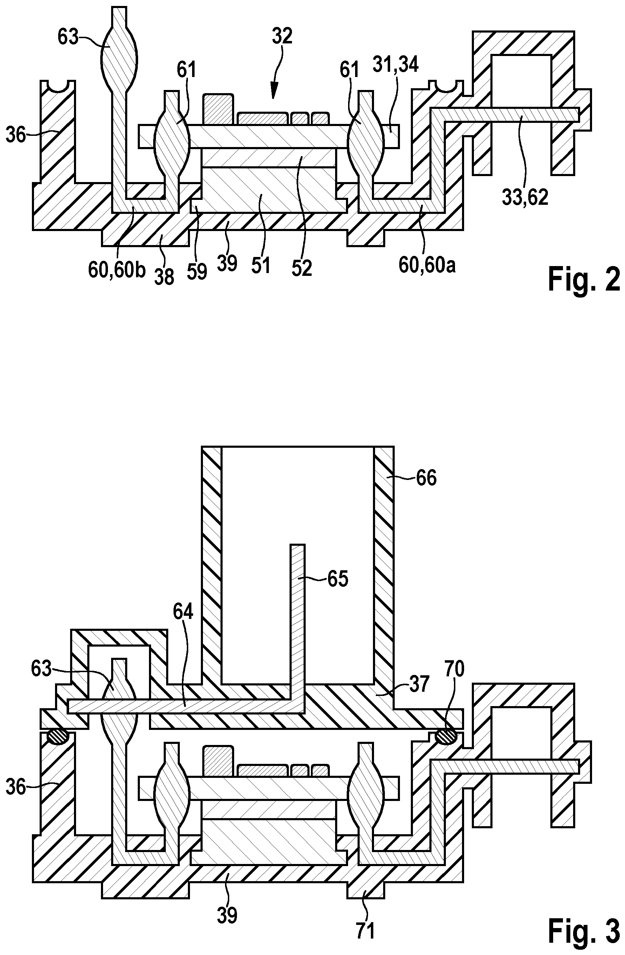

Figur 2 zeigt das Gehäuseunterteil 35 in einer vergrößerten Darstellung bei abgenommenem Gehäusedeckelteil 36. Das Gehäuseunterteil 35 kann beispielsweise als Spritzgussteil aus einem elektrisch nichtleitenden Kunststoff gefertigt werden. Wie in Figur 2 zu erkennen ist, können als Stanzgitterteile 60 ausgebildete Metallleiter in den Kunststoff eingespritzt werden. Die Stanzgitterteil 60 umfassen erste Stanzgitterteil 60a und zweite Stanzgitterteile 60b. Die der Leiterplatte 34 zugewandten Endabschnitte 61 der ersten Stanzgitterteile 60a und/oder der zweiten Stanzgitterteile 60b sind beispielsweise als Presskontakte ausgebildet und in entsprechende Kontaktierungsöffnungen der Leiterplatte 34 eingepresst. Die von der Leiterplatte 34 abgewandte Endabschnitte 62 der ersten Stanzgitterteile 60a sind als elektrischen Kontaktmittel 33 ausgebildet, die an einer Außenseite des Steuergerätegehäuses 35 zur Kontaktierung des elektrohydraulischen Aktuators 4 freiliegen. Wie dargestellt, können die Endabschnitte 62 an nur einer Seite des Gehäuseunterteils 35 zugänglich sein und auf den anderen Seiten zum Schutz von dem Kunststoff des Gehäuseunterteils 36 umgeben sein. Die der Leiterplatte 34 abgewandten Endabschnitte 63 der zweiten Stanzgitterteile 60b sind zur elektrischen Kontaktierung von in das Gehäusedeckelteil 37 eingebetteten dritten Stanzgitterteilen 64 ausgebildet, wie anhand der Figur 3 noch erläutert wird.

In Figur 2 ist weiterhin erkennbar, dass ein Schaltungsträger 31 vorgesehen ist, der eine auf einer ersten Seite mit elektronischen Bauelementen 32 versehene Leiterplatte 34 umfasst, die mit einer der ersten Seite gegenüberliegenden zweiten Seite über ein thermisches Ankoppelmaterial 52 unmittelbar auf einen Kühlblock 51 aufgebracht ist. Die Leiterplatte 34 kann beispielsweise ein Epoxidharzsubstrat (pcb: printed circuit board) mit darin eingebetteten Leiterbahnen aus Kupfer umfassen. Das thermische Ankoppelmaterial 53 kann beispielsweise einen Wärmeleitkleber umfassen. Die auf dem Schaltungsträger 31 durch die elektronischen Bauelemente 32 gebildete Steuerschaltung kann beispielsweise einen Microcontroller mit Spannungsversorgung, System-Basis-Funktionalität und Kommunikations-Schnittstellen für ein BUS System sowie wenigstens eine Leistungsendstufen zur Erzeugung und Modulierung eines Stellstroms des elektrohydraulischen Aktuators 4 umfassen. Es können aber gegebenenfalls auch weitere Bauelemente (beispielsweise Sensoren für Temperatur oder Druck, Speicherbausteine für Kennfelder und andere) auf dem Schaltungsträger 31 vorhanden sein.

Wie bereits erwähnt, umfasst die anhand der Figur 1 bereits erwähnte integrierte Kühlstruktur 50 einen in den Boden 38 des Gehäuseunterteils 36 eingelassenen Kühlblock 51. Der Kühlblock 51 kann durch einen in der Wanddicke verjüngten Gehäusewandabschnitt 39 des Bodens 38 vom Außenraum des Steuergerätegehäuses 35 getrennt sein, wie am besten in Figur 2 zu erkennen ist. Der dünnwandige Gehäusewandabschnitt 39 aus Kunststoff stellt aufgrund seiner dünnwandigen Ausführung mit einer Dicke von beispielsweise 0,5 bis 2 mm nur eine geringfügige Barriere für den Wärmefluss in Richtung des Hydraulikblocks 2 dar, ermöglicht jedoch eine vollständige Abdichtung des Bodenbereichs des Gehäuseunterteils 36. Das Gehäuseunterteil 36 kann wenigstens im Bereich des Gehäusewandabschnitts 39 aus einem gut wärmeleitenden Kunststoff bestehen. Die Kühlstruktur 50 umfasst also in dem hier gezeigten Ausführungsbeispiel den Kühlblock 51 und den Gehäusewandabschnitt 39. Der Kühlblock 51 besteht vorzugsweise aus Metall und wird bei der Herstellung des Gehäuseunterteils 36 aus Spritzgussmaterial seitlich mit dem Kunststoffmaterial des Gehäuseunterteils umspritzt. Weiterhin kann ein seitlich an der Unterseite von dem Kühlblock 51 abstehender Kragen 59 vorgesehen sein, der in den Kunststoff des Gehäuseunterteils 36 eingreift und die mechanische Festigkeit erhöht.

Wie in Figur 3 weiterhin gezeigt ist, umfasst das Steuergerätegehäuse 35 weiterhin ein Gehäusedeckelteil 37, das wie das Gehäuseunterteil 36 aus Kunststoff bestehen kann, in den im Spritzgussverfahren dritte Stanzgitterteile 64 eingebettet sind. Die aus dem Gehäuseinnenraum nach außen geführten Enden 65 der dritten Stanzgitterteile 64 bilden Kontaktelemente eines Steckerteils 66 für die Außenkontaktierung, beispielsweise für den Anschluss an einen externen Kabelbaum. Das Gehäusedeckelteil 37 kann über eine umlaufende Dichtung 70 auf einen Wandabschnitt des Gehäuseunterteils 36 aufgesetzt werden und dichtet das Steuergerätegehäuse 35 ab. Beim Aufsetzen des Gehäusedeckelteils 37 können die Endabschnitt 63 der zweiten Stanzgitterteile 60b in an dem Gehäuseinnenraum freiliegende Aufnahmeöffnungen der dritten Stanzgitterteile 64 eingepresst werden. Das Gehäusedeckelteil 37 und das Gehäuseunterteil 36 dichten den Gehäuseinnenraum vollständig ab. Es ist zu erkennen, dass die Leiterplatte 31 vollständig in dem abgedichteten Gehäuseinnenraum angeordnet ist.

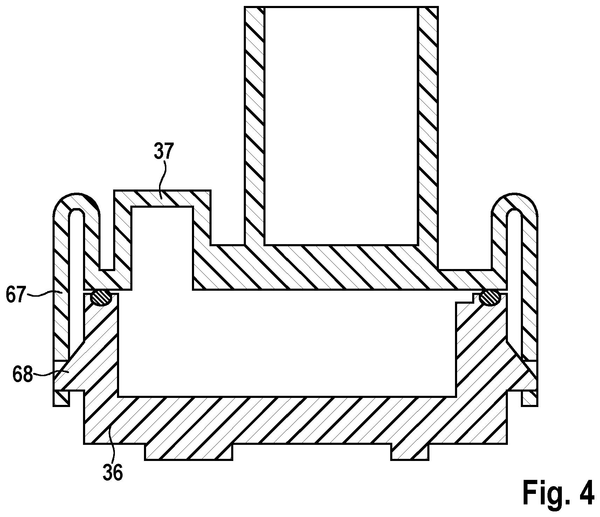

Figur 4 zeigt der Einfachheit halber nur das Gehäuseunterteil 36 und das an dem Gehäuseunterteil 36 angeordnete Gehäusedeckelteil 37. Das Gehäusedeckelteil 37 kann beispielsweise seitliche Rasthaken 67 aufweisen, die hinter Rastnasen 68 des Gehäuseunterteils 36 einrasten und dadurch das Gehäusedeckelteil 37 an dem Gehäuseunterteil 36 festlegen. Alternativ können beispielsweise auch schraubbare Befestigungsmittel oder anderen Befestigungsmöglichkeiten zum Einsatz kommen. Das Gehäuseunterteil 36 kann auf seiner von dem Gehäusedeckelteil 37 abweisenden Seite ein oder mehrere Podeste 71 zur Auflage an dem Hydraulikblock 2 aufweisen.

Figur 5 zeigt den Hydraulikblock 2 mit einem daran bereits angeordneten elektrohydraulischen Aktuator 4 vor der Aufbringung des Steuergerätes 3. Wie zu erkennen ist, weist der elektrohydraulische Aktuator 4 einen zur Auflage auf die Bestückungsseite 22 des Hydraulikblocks 2 ausgebildeten Flansch 44 aus Isolierstoff auf, in den mit der Magnetspule 45 des Elektromagneten 42 elektrisch verbundene Kontaktelemente 47 eingebettet sind. Die Kontaktelemente 47 können mit den Anschlüssen 46 der Magnetspule 45 beispielsweise verschweißt sein. Die Kontaktelemente 47 können als Stanzgitterteile ausgebildet sein und der Flansch 44 kann aus Kunststoff im Spritzverfahren an den Elektromagneten 42 angeformt werden. Die von der Magnetspule 45 abgewandten Enden der Kontaktelemente 47 sind als elektrische Anschlüsse 43 zur Kontaktierung der elektrischen Kontaktmitteln 33 des Steuergerätes 3 beispielsweise für eine Presskontaktierung ausgebildet. An dem Flansch 44 kann im Bereich der elektrischen Anschlüsse 43 eine Dichtung 48, beispielsweise ein O-Ring vorgesehen sein. Weiterhin ist die Bestückungsseite 22 des Hydraulikblocks 2 in der Nähe des elektrohydraulischen Aktuators 4 mit einem weiteren thermischen Ankoppelmaterial 72 versehen, bei dem es sich beispielsweise ebenfalls um einen Wärmeleitkleber handeln kann.

Zur Herstellung der fertigen elektrohydraulischen Steuervorrichtung 1 wird das Steuergerät 3 aus Figur 2 auf die Bestückungsseite 22 aufgesetzt. Dabei gelangen, wie in Figur 1 dargestellt ist, die Podeste 71 unmittelbar auf der Bestückungsseite 22 zur Anlage. Das weitere thermische Ankoppelmaterial 72 greift in den Raum zwischen den Podesten 71 ein und gelangt in direktem Kontakt mit dem Gehäusewandabschnitt 39 des Gehäusebodenteils 36. Bei Aufsetzen des Steuergerätes 3 werden die elektrischen Anschlüsse 43 des elektrohydraulischen Aktuators 4 automatisch in die Endabschnitte 62 der ersten Stanzgitterteile 60a eingepresst. Das Gehäuseunterteil 36 greift mit einem Abschnitt über die Dichtung 48, so dass die Kontaktstelle zwischen dem Steuergerät 3 und dem elektrohydraulischen Aktuator 4 nach außen abgedichtet wird.

## Patentansprüche

1. Elektrohydraulische Steuervorrichtung (1), umfassend einen mit wenigstens einem Hydraulikkanal (21) versehenen Hydraulikblock (2) mit einer Bestückungsseite (22), einem mit einem Ventilabschnitt (41) in eine Aufnahmeöffnung (23) des Hydraulikblocks (2) eingreifenden elektrohydraulischen Aktuator (4) und einem auf der Bestückungsseite (22) des Hydraulikblocks (2) befestigten elektronischen Steuergerät (3), wobei das Steuergerät (3) einen als Leiterplatte (34) ausgebildeten Schaltungsträger (31) mit darauf angeordneten elektronischen Bauelementen (32) und elektrische Kontaktmittel (33) aufweist, die mit elektrischen Anschlüssen (43) des elektrohydraulischen Aktuators (4) elektrisch kontaktiert sind, wobei die Leiterplatte (34) vollständig in einem geschlossenen und nach außen abgedichteten Steuergerätegehäuse (35) des Steuergerätes (3) auf einer in das Steuergerätegehäuse (35) integrierten Kühlstruktur (50) angeordnet ist und die Kühlstruktur (50) wärmeleitend mit der Bestückungsseite (22) des Hydraulikblocks (2) kontaktiert ist, wobei das Steuergerätegehäuse (35) ein Gehäuseunterteil (36) und ein auf das Gehäuseunterteil (36) aufgesetztes Gehäusedeckelteil (37) aufweist, **dadurch gekennzeichnet, dass** das Gehäuseunterteil (36) aus einem elektrisch nichtleitenden Kunststoff mit in das Gehäuseunterteil (36) eingebetteten Stanzgitterteilen (60) gefertigt ist, wobei der Aktuator (4) von der Bestückungsseite (22) aus mit dem Ventilabschnitt (41) in die Aufnahmeöffnung (23) eingreift und das elektronische Steuergerät (3) auf der Bestückungsseite (22) neben dem elektrohydraulischen Aktuator (4) befestigt ist, wobei von der Leiterplatte (34) abgewandte Endabschnitte (62) von ersten Stanzgitterteilen (60a) die elektrischen Kontaktmittel (33) ausbilden und wobei von der Leiterplatte (34) abgewandte Endabschnitte (63) zweiter Stanzgitterteile (60b) zur elektrischen Kontaktierung von in das Gehäusedeckelteil (37) eingebetteten dritten Stanzgitterteilen (64) ausgebildet sind.

2. Elektrohydraulische Steuervorrichtung nach einem der vorstehenden Ansprüche, **dadurch gekennzeichnet, dass** das elektronische Steuergerät (3) zur Ansteuerung nur eines elektrohydraulischen Aktuators (4) vorgesehen ist und diesem direkt zugeordnet ist.

3. Elektrohydraulische Steuervorrichtung nach Anspruch 1 oder 2, **dadurch gekennzeichnet, dass** die Kühlstruktur (50) einen in das Gehäuseunterteil (36) eingelassenen Kühlblock (51) aufweist, der über ein thermisches Ankoppelmaterial (52) unmittelbar mit der Leiterplatte (34) wärmeleitend verbunden ist.

4. Elektrohydraulische Steuervorrichtung nach Anspruch 3, **dadurch gekennzeichnet, dass** das Gehäuseunterteil (36) einen Boden (38) aufweist und der Kühlblock (51) in den Boden (38) des Gehäuseunterteils (36) eingelassen ist.

5. Elektrohydraulische Steuervorrichtung nach Anspruch 4, **dadurch gekennzeichnet, dass** der Kühlblock (51) durch einen in der Wanddicke verjüngten Gehäusewandabschnitt (39) des Bodens (38) vom Außenraum des Steuergerätegehäuses (35) getrennt ist.

6. Elektrohydraulische Steuervorrichtung nach einem der Ansprüche 1 bis 5, **dadurch gekennzeichnet, dass** der Boden (38) des Gehäuseunterteils (36) an einer der Kühlstruktur (50) gegenüberliegenden Seite mittels eines weiteren thermisches Ankoppelmaterials (72) direkt auf die Bestückungsseite (22) des Hydraulikblocks (2) wärmeleitend aufgebracht ist.

7. Elektrohydraulische Steuervorrichtung nach Anspruch 1, **dadurch gekennzeichnet, dass** der Leiterplatte (34) zugewandten Endabschnitte der ersten Stanzgitterteile (60a) und/oder der zweiten Stanzgitterteile (60b) als Presskontakte in die Leiterplatte (34) eingepresst sind.

8. Elektrohydraulische Steuervorrichtung nach einem der vorstehenden Ansprüche, **dadurch gekennzeichnet, dass** der elektrohydraulische Aktuator (4) eine Magnetspule (45) und einen zur Auflage auf die Bestückungsseite (22) des Hydraulikblocks (2) ausgebildeten Flansch (44) aufweist, in den mit der Magnetspule (45) elektrisch verbundene Kontaktelemente (47) eingebettet, wobei von der Magnetspule (45) abgewandte Enden der Kontaktelemente (47) als elektrische Anschlüsse (43) ausgebildet sind, die mit den elektrischen Kontaktmitteln (33) des Steuergerätes (3) direkt kontaktiert sind.

## Claims

1. Electrohydraulic control device (1), comprising a hydraulic block (2) which is provided with at least one hydraulic duct (21) and has a component side (22), an electrohydraulic actuator (4) engaging by way of a valve portion (41) into a receiving opening (23) in the hydraulic block (2), and an electronic control unit (3) mounted on the component side (22) of the hydraulic block (2), wherein the control unit (3) has a circuit carrier (31) which is designed as a printed circuit board (34) and has arranged on it electronic components (32) and electrical contact means (33) which are electrically contacted with electrical connections (43) of the electrohydraulic actuator (4), wherein the printed circuit board (34) is arranged completely in a closed and outwardly sealed control unit housing (35) of the control unit (3) on a cooling structure (50) integrated into the control unit housing (35), and the cooling structure (50) is thermally conductively contacted with the component side (22) of the hydraulic block (2), wherein the control unit housing (35) has a housing lower part (36) and a housing cover part (37) placed onto the housing lower part (36), **characterized in that** the housing lower part (36) is manufactured from an electrically non-conductive plastic with leadframe parts (60) embedded in the housing lower part (36), wherein the actuator (4) engages by way of the valve portion (41) into the receiving opening (23) from the component side (22) and the electronic control unit (3) is mounted next to the electrohydraulic actuator (4) on the component side (22), wherein end portions (62) of first leadframe parts (60a) facing away from the printed circuit board (34) form the electrical contact means (33), and wherein end portions (63) of second leadframe parts (60b) facing away from the printed circuit board (34) are designed for electrically contacting third leadframe parts (64) embedded in the housing cover part (37).

2. Electrohydraulic control device according to any of the preceding claims, **characterized in that** the electronic control unit (3) is provided for actuating only one electrohydraulic actuator (4) and is assigned directly to the electrohydraulic actuator.

3. Electrohydraulic control device according to Claim 1 or 2, **characterized in that** the cooling structure (50) has a cooling block (51) which is incorporated into the housing lower part (36) and is thermally conductively connected directly to the printed circuit board (34) via a thermal coupling material (52).

4. Electrohydraulic control device according to Claim 3, **characterized in that** the housing lower part (36) has a base (38) and the cooling block (51) is incorporated into the base (38) of the housing lower part (36).

5. Electrohydraulic control device according to Claim 4, **characterized in that** the cooling block (51) is separated from the outside space of the control unit housing (35) by a housing wall section (39) of the base (38) that has a tapering wall thickness.

6. Electrohydraulic control device according to any of Claims 1 to 5, **characterized in that** the base (38) of the housing lower part (36) is thermally conductively applied directly to the component side (22) of the hydraulic block (2) on a side opposite the cooling structure (50) by means of a further thermal coupling material (72).

7. Electrohydraulic control device according to Claim 1, **characterized in that** end portions of the first leadframe parts (60a) and/or of the second leadframe parts (60b) facing the printed circuit board (34) are pressed into the printed circuit board (34) as press contacts.

8. Electrohydraulic control device according to any of the preceding claims, **characterized in that** the electrohydraulic actuator (4) has a magnet coil (45) and a flange (44) which is designed to rest on the component side (22) of the hydraulic block (2) and in which contact elements (47) electrically connected to the magnet coil (45) are embedded, wherein ends of the contact elements (47) facing away from the magnet coil (45) are designed as electrical connections (43) which are directly contacted with the electrical contact means (33) of the control unit (3).

## Revendications

1. Dispositif de commande électrohydraulique (1) comprenant un bloc hydraulique (2) pourvu d'au moins un canal hydraulique (21) avec un côté d'équipement (22), un actionneur (4) électrohydraulique venant en prise avec une ouverture de réception (23) du bloc hydraulique (2) par une section de soupape (41) et un appareil de commande (3) électronique fixé sur le côté d'équipement (22) du bloc hydraulique (2), l'appareil de commande (3) comportant un support de circuit (31) formé comme une carte de circuits imprimés (34) avec des composants électroniques (32) disposés dessus et des moyens de contact électriques (33), qui sont en contact électrique avec des bornes électriques (43) de l'actionneur (4) électrohydraulique, la carte de circuits imprimés (34) étant disposée complètement dans un boîtier (35) d'appareil de commande fermé et étanchéifié par rapport à l'extérieur de l'appareil de commande (3) sur une structure de refroidissement (50) intégrée dans le boîtier (35) d'appareil de commande et la structure de refroidissement (50) étant en contact thermoconducteur avec le côté d'équipement (22) du bloc hydraulique (2), le boîtier (35) d'appareil de commande comportant une partie inférieure (36) de boîtier et une partie de couvercle (37) de boîtier placée sur la partie inférieure (36) de boîtier, **caractérisé en ce que** la partie inférieure (36) de boîtier est produite à partir d'une matière plastique non conductrice électriquement avec des parties de treillis estampées (60) intégrées dans la partie inférieure (36) de boîtier, l'actionneur (4) venant en prise avec l'ouverture de réception (23) par la section de soupape (41) depuis le côté d'équipement (22) et l'appareil de commande (3) électronique étant fixé sur le côté d'équipement (22) à côté de l'actionneur (4) électrohydraulique, des sections d'extrémité (62), opposées à la carte de circuits imprimés (34), de premières parties de grille estampées (60a) formant les moyens de contact électriques (33) et des sections d'extrémité (63), opposées à la carte de circuits imprimés (34), de deuxièmes parties de grille estampées (60b) étant formées pour entrer en contact électrique avec des troisièmes parties de grille estampées (64) intégrées dans la partie de couvercle (37) de boîtier.

2. Dispositif de commande électrohydraulique selon l'une des revendications précédentes, **caractérisé en ce que** l'appareil de commande (3) électronique est prévu pour piloter seulement un actionneur (4) électrohydraulique et est directement associé à celui-ci.

3. Dispositif de commande électrohydraulique selon la revendication 1 ou 2, **caractérisé en ce que** la structure de refroidissement (50) comporte un bloc de refroidissement (51) encastré dans la partie inférieure (36) de boîtier, qui est relié de manière thermoconductrice directement à la carte de circuits imprimés (34) par un matériau de couplage thermique (52).

4. Dispositif de commande électrohydraulique selon la revendication 3, **caractérisé en ce que** la partie inférieure (36) de boîtier comporte un fond (38) et le bloc de refroidissement (51) est encastré dans le fond (38) de la partie inférieure (36) de boîtier.

5. Dispositif de commande électrohydraulique selon la revendication 4, **caractérisé en ce que** le bloc de refroidissement (51) est séparé de l'espace extérieur du boîtier (35) de l'appareil de commande par une section de paroi de boîtier (39) du fond (38) rétrécie dans l'épaisseur de paroi.

6. Dispositif de commande électrohydraulique selon l'une des revendications 1 à 5, **caractérisé en ce que** le fond (38) de la partie inférieure (36) de boîtier sur un côté faisant face à la structure de refroidissement (50) est installé de manière thermoconductrice directement sur le côté d'équipement (22) du bloc hydraulique (2) au moyen d'un autre matériau de couplage thermique (72).

7. Dispositif de commande électrohydraulique selon la revendication 1, **caractérisé en ce que** les sections d'extrémité, tournées vers la carte de circuits imprimés (34), des premières parties de grille estampées (60a) et/ou des deuxièmes parties de grille estampées (60b) sont pressées dans la carte de circuits imprimés (34) en tant que contacts de pressage.

8. Dispositif de commande électrohydraulique selon l'une des revendications précédentes, **caractérisé en ce que** l'actionneur (4) électrohydraulique comporte une bobine magnétique (45) et une bride (44) formée pour s'appuyer sur le côté d'équipement (22) du bloc hydraulique (2), dans laquelle sont intégrés des éléments de contact (47) reliés électriquement à la bobine magnétique (45), les extrémités des éléments de contact (47) opposées à la bobine magnétique (45) étant formées comme des bornes électriques (43) qui sont directement en contact avec les moyens de contact électrique (33) de l'appareil de commande (3).
